# EUROPEAN PATENT APPLICATION

(11) **EP 4 382 959 A1**
(43) Date of publication of application: **12.06.2024**
(21) Application number: 23195363.9
(22) Date of filing: 05.09.2023
(51) Int. Cl.: G01S 7/4863, G01S 7/497

(54) **PHOTODETECTION DEVICE AND DISTANCE MEASUREMENT DEVICE**

(30) Priority: 09.12.2022 JP 2022197377
(71) Applicant: KABUSHIKI KAISHA TOSHIBA, Minato-ku Tokyo 105-0023 (JP)
(72) Inventor: Sugimoto, Toshiki, Tokyo (JP); Ta, Tuan Thanh, Tokyo (JP); Sai, Akihide, Tokyo (JP)
(74) Representative: Hoffmann Eitle

(57) **Abstract**

A photodetection device (1) has a photodetection element (2), an reset circuit (3) that sets one end of the photodetection element (2) to a predetermined initialization voltage, a firing detection circuit (4) (4) that detects firing of the photodetection element (2) by comparing a voltage at the one end of the photodetection element (2) or a current flowing through the one end with a threshold, a monitor circuit (5) that monitors an output signal of the firing detection circuit (4) (4), and a threshold control circuit (6) that controls the threshold based on a monitor output of the monitor circuit (5).

## Description

### FIELD

An example of the present invention relates to a photodetection device and a distance measurement device.

### BACKGROUND

A light detecting and ranging (LiDAR) device that measures a distance of an object in a non-contact manner is an important key part in an autonomous driving technology. The LiDAR receives reflected light reflected by an object by a plurality of photoelectric conversion elements arranged in a two-dimensional array. For example, a single photon avalanche diode (SPAD) is used as the photoelectric conversion element. When the SPAD detects a photon, an output voltage or an output current of the SPAD changes. A state in which the SPAD detects photons is called firing. By comparing the output voltage or the output current of the SPAD when the SPAD fires with a predetermined threshold, it is possible to detect whether or not the SPAD receives reflected light from an object.

However, the output voltage or the output current when each of the SPADs arranged in a two-dimensional array fires may fluctuate for each SPAD. For this reason, when the thresholds of all the SPADs in the LiDAR device are uniformly set, it is not possible to correctly detect whether or not each SPAD has fired.

### BRIEF DESCRIPTION OF THE DRAWINGS

FIG. 1A is a block diagram illustrating a schematic configuration of a photodetection device including an active quenching circuit;
FIG. 1B is a block diagram illustrating a schematic configuration of a photodetection device including a passive quenching circuit;
FIG. 2 is a graph illustrating a relationship between a threshold of a firing detection circuit and an occurrence rate of a dark pulse detected by the firing detection circuit;
FIG. 3A is a diagram illustrating a relationship between a threshold voltage and a dark count rate;
FIG. 3B is a waveform diagram of a cathode voltage of a photodetection element and an output current of the firing detection circuit;
FIG. 4A is a diagram illustrating a relationship between a threshold voltage and a dark count rate;
FIG. 4B is a waveform diagram of a cathode voltage of the photodetection element and an output current of the firing detection circuit;
FIG. 5A is a diagram illustrating a relationship between a threshold voltage and a dark count rate;
FIG. 5B is a waveform diagram of a cathode voltage of the photodetection element and an output current of the firing detection circuit;
FIG. 6A is a diagram illustrating a relationship between a threshold voltage and a dark count rate;
FIG. 6B is a waveform diagram of a cathode voltage of the photodetection element and an output current of the firing detection circuit;
FIG. 7 is a flowchart illustrating a first example of a processing operation of a photodetection device according to a first example;
FIG. 8 is a flowchart illustrating a second example of the processing operation of the photodetection device according to the first example;
FIG. 9A is a diagram illustrating a reason why a minimum value of a control range of a threshold in which a variation amount of a dark count rate falls within a predetermined amount is set as a threshold;
FIG. 9B is a diagram illustrating a reason why the minimum value of the control range of the threshold in which the variation amount of the dark count rate falls within a predetermined amount is set as the threshold;
FIG. 10 is a block diagram of a photodetection device according to a first specific example in which a firing detection circuit is embodied;
FIG. 11 is a block diagram of a photodetection device according to a second specific example in which a firing detection circuit is embodied;
FIG. 12 is a block diagram illustrating a specific example of a monitor circuit of FIG. 11;
FIG. 13 is a block diagram illustrating a schematic configuration of a photodetection device according to a second example;
FIG. 14 is a block diagram illustrating a schematic configuration of a photodetection device according to a modified example of FIG. 13;
FIG. 15 is a block diagram illustrating a schematic configuration of a distance measurement device including a photodetection device according to a third example;
FIG. 16 is a block diagram illustrating a schematic configuration of a distance measurement device according to a first modified example of the third example; and
FIG. 17 is a block diagram illustrating a schematic configuration of a distance measurement device according to a second modified example of the third example.

### DETAILED DESCRIPTION

According to one example, a photodetection device has a photodetection element, an reset circuit that sets one end of the photodetection element to a predetermined initialization voltage, a firing detection circuit that detects firing of the photodetection element by comparing a voltage at the one end of the photodetection element or a current flowing through the one end with a threshold, a monitor circuit that monitors an output signal of the firing detection circuit, and a threshold control circuit that controls the threshold based on a monitor output of the monitor circuit.

Hereinafter, examples of a photodetection device and a distance measurement device will be described with reference to the drawings. Hereinafter, main components of the photodetection device and the distance measurement device will be mainly described, but the photodetection device and the distance measurement device may have components and functions that are not illustrated or described. The following description does not exclude components and functions that are not illustrated or described.

### (First example)

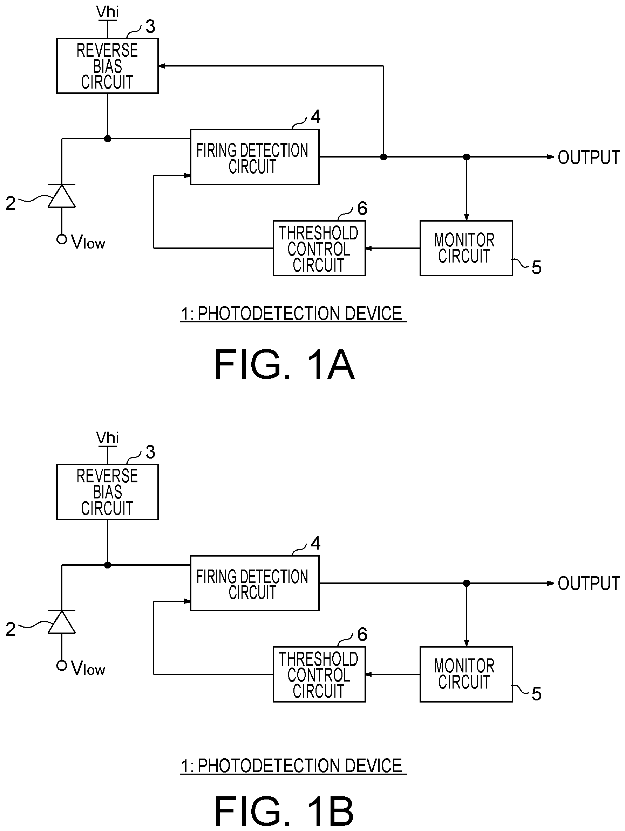

FIGS. 1A and 1B are block diagrams illustrating a schematic configuration of a photodetection device 1 according to a first example. The photodetection circuit of FIGS. 1A and 1B is a circuit that receives reflected light in which light projected onto an object is reflected by the object.

The photodetection device 1 of FIGS. 1A and 1B includes a photodetection element 2, a reverse bias circuit 3, a firing detection circuit 4, a monitor circuit 5, and a threshold control circuit 6.

The photodetection element 2 is, for example, a single photon avalanche diode (SPAD). The SPAD operates an Avalanche Photo-Diode (APD) in Geiger mode, and can output an electric signal obtained by photoelectrically converting one received photon. As will be described later, a pixel array unit in which a plurality of the photodetection elements 2 is arranged in a one-dimensional or two-dimensional direction may be provided, or a single photodetection element 2 may be provided in the photodetection device 1. In the present specification, two terminals included in the photodetection element 2 are referred to as an anode and a cathode.

The reverse bias circuit 3 is an reset circuit that sets one end (for example, a cathode) of the photodetection element 2 to a predetermined initialization voltage. In the present specification, detection (reception) of photons by the photodetection element 2 is referred to as firing. When the photodetection element 2 fires, a voltage (cathode voltage) on one end side of the photodetection element 2 decreases. When the photodetection element 2 fires and the cathode voltage of the photodetection element 2 decreases, the reverse bias circuit 3 performs an operation of restoring the cathode voltage to the original initialization voltage. The reverse bias circuit 3 may return the cathode voltage of the photodetection element 2 to the initialization voltage based on an output signal of the firing detection circuit 4 described later, or may return the cathode voltage of the photodetection element 2 to the initialization voltage regardless of the output signal of the firing detection circuit 4.

The firing detection circuit 4 detects firing of the photodetection element 2 by comparing a voltage at one end (cathode) of the photodetection element 2 or a current flowing through one end with a threshold. FIG. 1A illustrates an active quenching circuit in which the reverse bias circuit 3 returns one end of the photodetection element 2 to an initialization voltage based on an output signal of the firing detection circuit 4. On the other hand, FIG. 1B illustrates a passive quenching circuit in which the reverse bias circuit 3 returns one end of the photodetection element 2 to an initialization voltage independently of an output signal of the firing detection circuit 4.

As described above, the firing detection circuit 4, the monitor circuit 5, and the threshold control circuit 6 according to the first example are applicable to both an active quenching circuit and a passive quenching circuit.

The firing detection circuit 4 detects firing of the photodetection element 2. It is detected that the photodetection element 2 spontaneously fires in a situation in which light is shielded or the photodetection element 2 fires in a situation in which light is incident on the photodetection element 2.

The photodetection element 2 may spontaneously fire due to thermally generated carriers without depending on an amount of incident light to generate a pulse, and is called a dark pulse. The dark pulse can be detected by appropriately setting a threshold of the firing detection circuit. Furthermore, the photodetection element 2 fires and generates a pulse according to ambient light such as sunlight. The firing pulse due to ambient light can also be detected by appropriately setting a threshold of the firing detection circuit. Whether the firing detection circuit 4 can detect firing of the photodetection element 2 depends on the threshold setting of the firing detection circuit 4.

The monitor circuit 5 monitors an output signal of the firing detection circuit 4. For example, the monitor circuit 5 counts the number of times the firing detection circuit 4 has detected firing, and outputs the counted number as a monitor output. The monitor circuit 5 monitors firing based on the dark pulse or ambient light detected by the firing detection circuit 4. Specifically, the monitor circuit 5 counts the number of times the firing detection circuit 4 has detected firing based on a dark pulse or ambient light.

The threshold control circuit 6 controls a threshold of the firing detection circuit 4 based on the monitor output of the monitor circuit 5. For example, the threshold control circuit 6 controls the threshold so that a detection rate of firing in the firing detection circuit 4 is maximized.

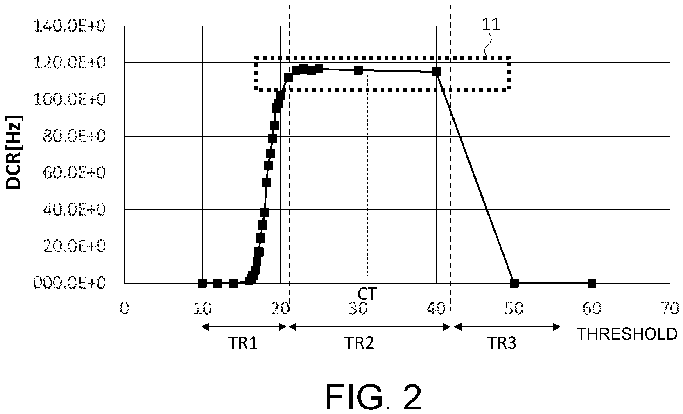

FIG. 2 is a graph illustrating a relationship between a threshold of the firing detection circuit 4 and the number of times of generation of dark pulses per unit time (Hereinafter, a dark count rate, DCR: Dark Count Rate) detected by the firing detection circuit 4. In FIG. 2, a horizontal axis represents a threshold set value, and a vertical axis represents a dark count rate. In FIG. 2, the thresholds of the firing detection circuit 4 are classified into three (first to third threshold ranges) TR1, TR2, and TR3 in order of magnitude. The threshold increases in the order of the first threshold range TR1, the second threshold range TR2, and the third threshold range TR3. When the threshold of the firing detection circuit 4 is within the first threshold range TR1, the dark count rate by the firing detection circuit 4 increases as the threshold increases, and becomes substantially zero as the threshold decreases. When the threshold of the firing detection circuit 4 is within the second threshold range TR2, the dark count rate by the firing detection circuit 4 holds the maximum value. When the threshold of the firing detection circuit 4 is within the third threshold range TR3, the dark count rate by the firing detection circuit 4 decreases as the threshold increases, and becomes substantially zero as the threshold increases.

The threshold control circuit 6 may have a function of searching for an optimum threshold by continuously or intermittently changing (sweeping) the threshold of the firing detection circuit 4. The optimum threshold is within the second threshold range TR2 in which the dark count rate is maximized. More specifically, the threshold control circuit 6 may control the threshold so that a count value of a counter in the monitor circuit 5 falls within a predetermined variation rate by continuously or intermittently changing the threshold of the firing detection circuit 4. Within the predetermined variation rate means a dark count rate within the second threshold range TR2 where the dark count rate becomes substantially the maximum value, and is within a range of a broken-line frame 11 in FIG. 2.

Furthermore, the threshold control circuit 6 may set the threshold to a median value of a control range of the threshold in which the count value of the counter falls within a predetermined variation rate. Alternatively, the threshold control circuit 6 may set the threshold to the minimum value of the control range of the threshold in which the count value of the counter falls within the variation rate. That is, the threshold is set to the median value or the minimum value within the range of the broken-line frame 11 in FIG. 2.

The firing detection circuit 4 can detect firing based on a result of comparison between a cathode voltage of the photodetection element 2 and a threshold voltage output from the threshold control circuit 6.

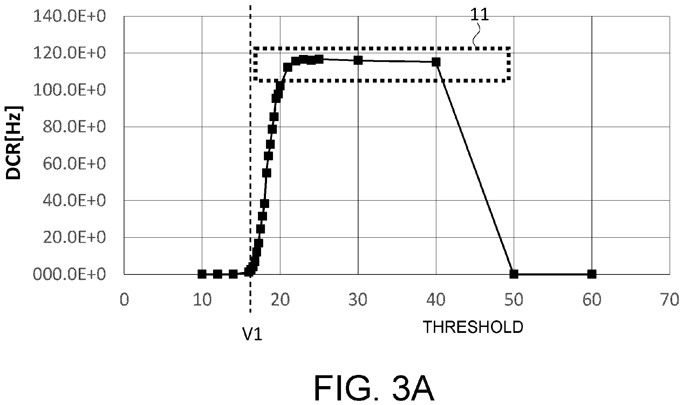

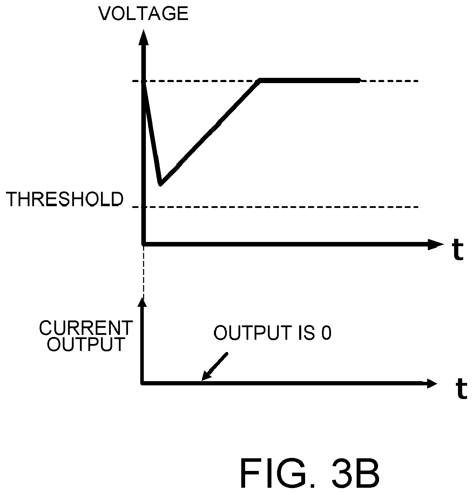

FIGS. 3A and 3B are characteristic diagrams when a threshold voltage Vth of the firing detection circuit 4 is less than or equal to a first voltage V1, FIG. 3A is a diagram illustrating a relationship between the threshold voltage Vth and the dark count rate, and FIG. 3B is a waveform diagram of the cathode voltage of the photodetection element 2 and an output current of the firing detection circuit 4.

As illustrated in FIG. 3B, when the photodetection element 2 fires, the cathode voltage of the photodetection element 2 rapidly decreases to reach the minimum voltage, and then gradually increases to return to the original initialization voltage. Since the first voltage is lower than the minimum voltage when the photodetection element 2 fires, the firing detection circuit 4 does not detect firing as illustrated in FIG. 3A, and almost no current flows through the cathode of the firing detection circuit 4 as illustrated in FIG. 3B.

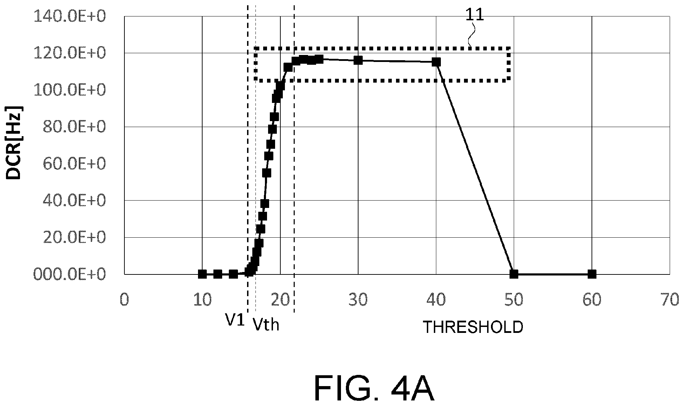

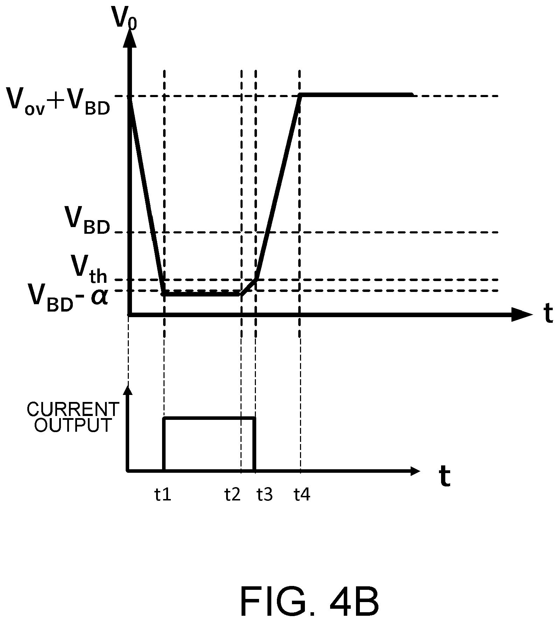

FIGS. 4A and 4B are characteristic diagrams when the threshold voltage Vth of the firing detection circuit 4 is near the first voltage V1, FIG. 4A is a diagram illustrating a relationship between the threshold voltage Vth and the dark count rate, and FIG. 4B is a waveform diagram of the cathode voltage of the photodetection element 2 and the output current of the firing detection circuit 4.

FIG. 4B illustrates a cathode voltage of the photodetection element 2 when the reverse bias circuit 3 and the firing detection circuit 4 constitute an active quenching circuit. As illustrated in FIG. 4B, the active quenching circuit performs an reset operation in two stages, for example. When the photodetection element 2 fires and the cathode voltage decreases (time t1), the cathode voltage is held at a voltage (VBD-a) lower than a breakdown voltage VBD within a period from time t1 to time t2. Thereafter, during a period from time t2 to time t3, the reverse bias circuit 3 performs a first-stage reset operation. When the cathode voltage becomes higher than the threshold voltage Vth (time t3), the reverse bias circuit 3 performs a second-stage reset operation within a period from time t3 to time t4. In the second-stage reset operation, the cathode voltage of the photodetection element 2 returns to the initialization voltage.

When the threshold voltage Vth is around the first voltage V1, as illustrated in FIG. 4B, the threshold voltage Vth is about the same as the breakdown voltage of the light emitting element. Therefore, the threshold voltage Vth may not exceed the threshold voltage Vth due to the influence of noise, and all fires cannot be detected. Therefore, the dark count rate is higher than that in FIG. 3A, but is less than the maximum value.

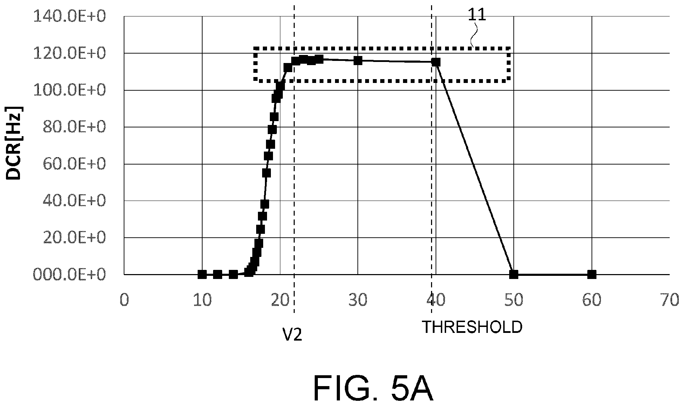

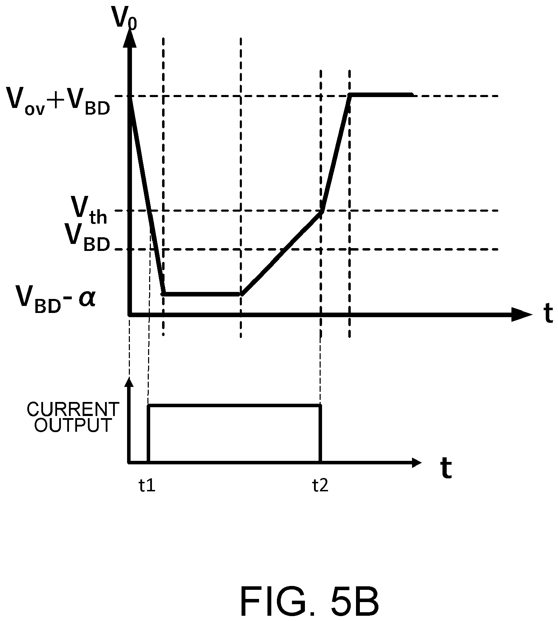

FIGS. 5A and 5B are characteristic diagrams when the threshold voltage Vth of the firing detection circuit 4 is near a second voltage V2, FIG. 5A is a diagram illustrating a relationship between the threshold voltage Vth and the dark count rate, and FIG. 5B is a waveform diagram of the cathode voltage of the photodetection element 2 and the output current of the firing detection circuit 4.

When the threshold voltage Vth is around the second voltage V2, the threshold voltage Vth becomes an appropriate voltage level as illustrated in FIG. 5B, and all fires can be detected without being affected by noise, so that the dark count rate becomes maximum as illustrated in FIG. 5A.

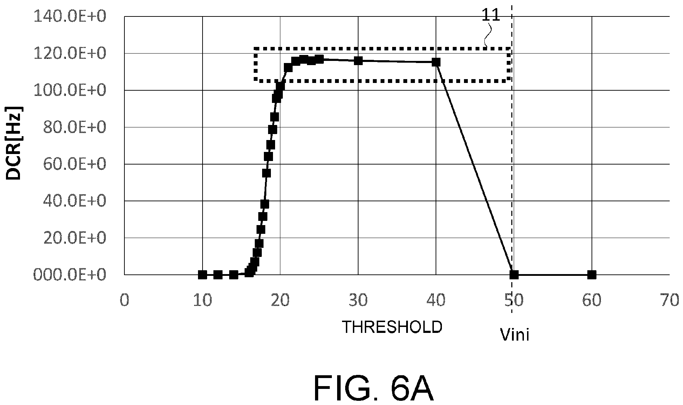

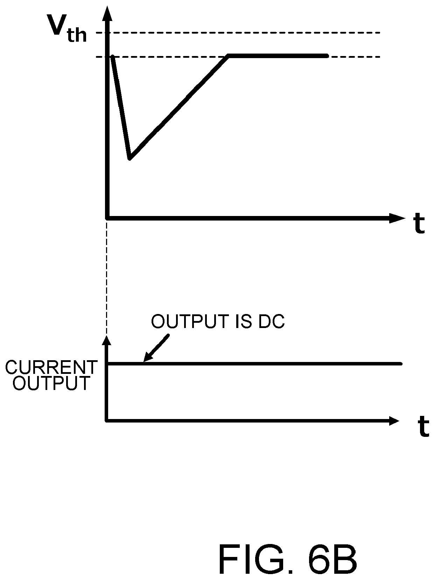

FIGS. 6A and 6B are characteristic diagrams when the threshold voltage Vth of the firing detection circuit 4 is higher than or equal to the initialization voltage, FIG. 6A is a diagram illustrating a relationship between the threshold voltage Vth and the dark count rate, and FIG. 6B is a waveform diagram of the cathode voltage of the photodetection element 2 and the output current of the firing detection circuit 4.

In a case where the threshold voltage Vth is higher than or equal to the initialization voltage, since the cathode voltage constantly exceeds the threshold voltage Vth, the firing detection circuit 4 constantly detects firing whether or not photodetection element2 actually fires, and the output current is constant. Therefore, firing of the photodetection element 2 cannot be detected dark count rate becomes minimum as illustrated in FIG. 6A.

In FIGS. 3B, 4B, 5B, and 6B, the waveform of the output current of the firing detection circuit 4 is illustrated, but the waveform of the output voltage of the firing detection circuit 4 also changes according to the voltage level of the threshold voltage Vth similarly to the waveform of the output current, and outputs a pulsed voltage signal (Hereinafter, a pulse signal) when detecting firing.

As can be seen from FIGS. 3A, 3B, 4A, 4B, 5A, 5B, 6A, and 6B, the threshold control circuit 6 changes (sweeps) the threshold voltage Vth from the first voltage V1 to the initialization voltage, whereby the dark count rate changes. The dark count rate is maximized when the threshold voltage Vth of the firing detection circuit 4 is around the second voltage V2, and at this time, the firing detection circuit 4 outputs a pulse signal.

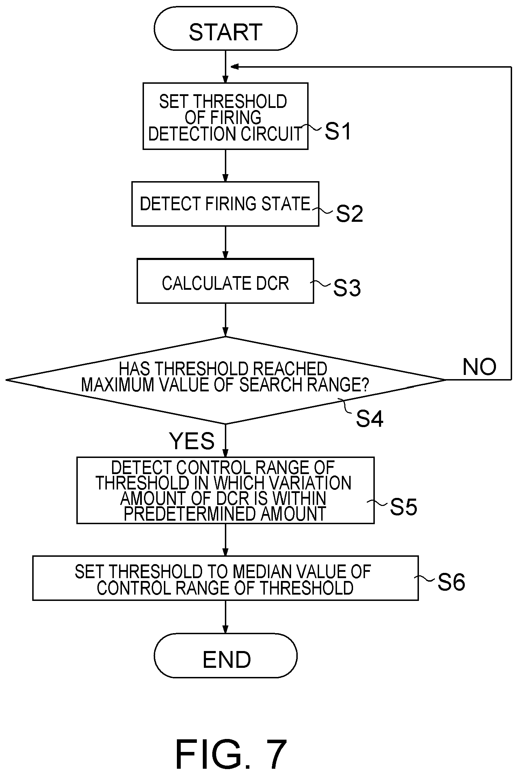

FIG. 7 is a flowchart illustrating a first example of a processing operation of the photodetection device 1 according to the first example. The processing of the flowchart of FIG. 7 is performed in a state where the photodetection element 2 is shielded from light or in a situation where ambient light with uniform illuminance is incident on the photodetection element 2.

First, a threshold of the firing detection circuit 4 is set (step S1). The threshold is a threshold voltage or a threshold current. The threshold control circuit 6 continuously or intermittently changes the threshold within a predetermined search range. In the flowchart of FIG. 7, an example in which the threshold control circuit 6 sequentially increases the threshold from the minimum value in the search range will be described.

Next, the monitor circuit 5 detects a firing state of the firing detection circuit 4 (step S2). The firing state indicates a state in which the firing detection circuit 4 has detected firing or a state in which the firing detection circuit 4 has not detected firing, and is detected by an output signal of the firing detection circuit 4. For example, when the firing detection circuit 4 detects firing, the firing detection circuit 4 outputs a pulse signal. This pulse signal represents a dark pulse having an occurrence rate according to the threshold.

Next, the monitor circuit 5 counts the pulse signal output from the firing detection circuit 4 and calculates a dark count rate (step S3). The dark count rate is calculated by the number of pulses of the pulse signal output from the firing detection circuit 4 within the unit time.

Next, it is determined whether or not the threshold has reached the maximum value of the search range (step S4). In a case where the threshold has not reached the maximum value of the search range, the processing in and after step S1 is repeated. In a case where the threshold reaches the maximum value of the search range, the threshold control circuit 6 detects a control range of the threshold in which a variation amount of the dark count rate falls within a predetermined amount (step S5). A median value of the control range of the detected threshold is set as a threshold of the firing detection circuit 4 (step S6).

For example, the broken-line frame 11 in FIG. 2 indicates a range in which the variation amount of the dark count rate is within the predetermined amount. In step S5 of FIG. 7, the threshold of the firing detection circuit 4 is set to the median value CT in the broken-line frame 11 of FIG. 2. By setting the median of the control range of the threshold in which the variation amount of the dark count rate falls within the predetermined amount as the threshold, there is no possibility that the set threshold deviates from the optimum range even if PVT (Process, Voltage, Temperature) changes, and robust threshold setting can be performed.

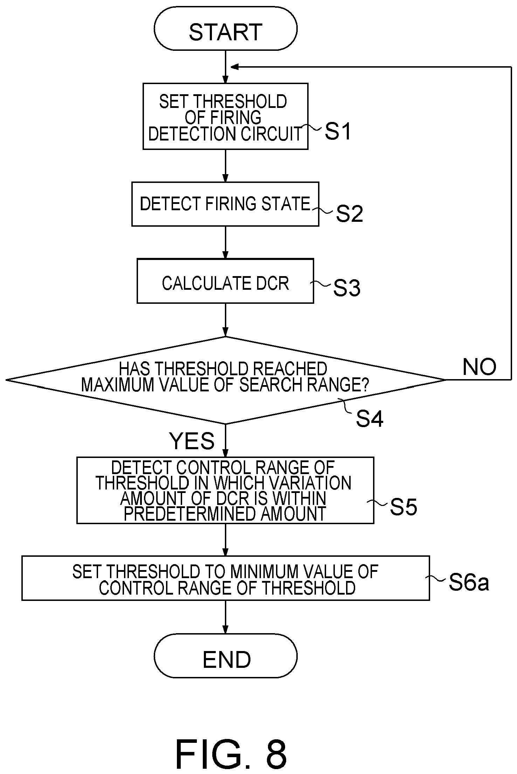

FIG. 8 is a flowchart illustrating a second example of the processing operation of the photodetection device 1 according to the first example. In FIG. 8, processes common to those in FIG. 7 are denoted by the same step numbers, and differences will be mainly described below. In the flowchart of FIG. 8, the processing of steps S1 to S4 is performed similarly to FIG. 7. When it is determined in step S4 that the threshold has reached the maximum value of the search range, the threshold control circuit 6 sets the threshold of the firing detection circuit 4 to the minimum value of the control range of the threshold in which the variation amount of the dark count rate falls within the predetermined amount (step S6a).

As described above, step S6a of FIG. 8 is different from step S6 of FIG. 7 in that the minimum value is set as the threshold instead of the median value of the control range of the threshold in which the variation amount of the dark count rate falls within the predetermined amount.

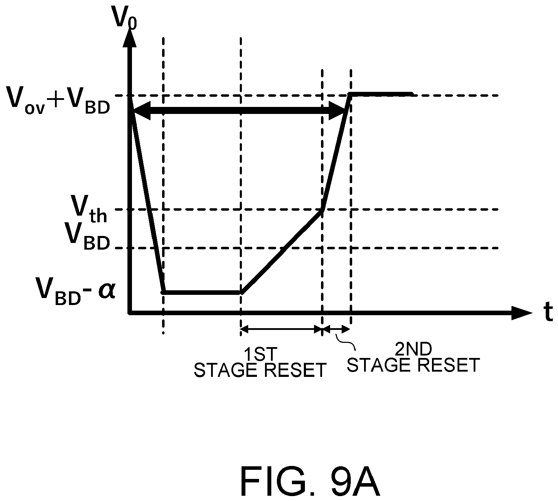

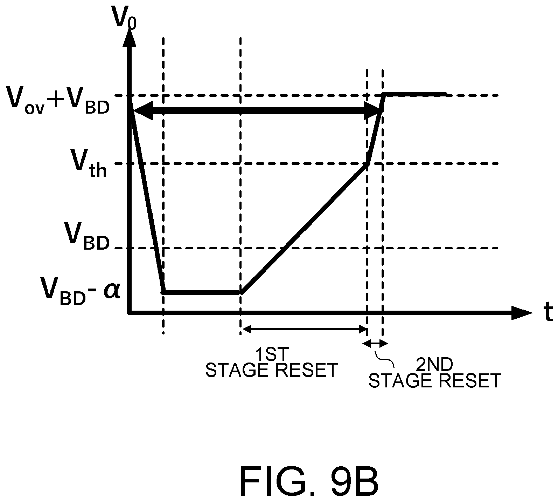

FIGS. 9A and 9B are diagrams for explaining the reason why the minimum value of the control range of the threshold in which the variation amount of the dark count rate falls within the predetermined amount in step S6a of FIG. 8 is set as the threshold.

In the active quenching circuit that performs an reset operation in two stages of slow recharge in a first stage and fast recharge in a second stage in order to prevent thermal breakdown of the SPAD, a dead time at which the photodetection element 2 cannot react depends on a threshold level. FIG. 9A illustrates an example in which the threshold voltage is lower than that in FIG. 9B. In FIGS. 9A and 9B, when the cathode voltage of the photodetection element 2 reaches the threshold voltage, the second-stage reset operation is started. The second-stage reset operation has a larger change amount of the cathode voltage per unit time than the first-stage reset operation. Therefore, the dead time can be further shortened by starting the second-stage reset operation when the threshold voltage is at a lower voltage level as illustrated in FIG. 9A.

As described above, from the viewpoint of further shortening the dead time, it is preferable to set the minimum value of the control range of the threshold as the threshold as in step S6a of FIG. 8 rather than to set the median value of the control range of the threshold as the threshold as in step S6 of FIG. 7, because the deadline can be further shortened.

In the flowcharts of FIGS. 7 and 8, the threshold is set on the basis of the dark count rate, but the threshold may be set on the basis of an incidence rate of firing by ambient light.

Furthermore, in the flowcharts of FIGS. 7 and 8, an example of using a linear search method of setting an optimum threshold by continuously or intermittently changing the threshold within the search range has been described. However, the optimum threshold may be set by a binary search method. By adopting the binary search method, the number of repetitions of processing until the optimal threshold is set can be reduced, and the optimal threshold can be set more quickly.

In the flowcharts of FIGS. 7 and 8, an example in which the median value or the minimum value of the control range of the threshold in which the variation amount of the dark count rate falls within the predetermined amount is set as the threshold of the firing detection circuit 4 has been described. However, an average value or the like of the control range of the threshold may be set as the threshold.

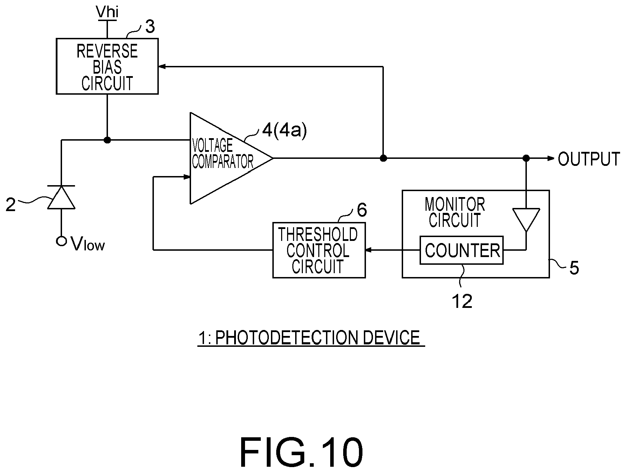

FIG. 10 is a block diagram of the photodetection device 1 according to the first specific example in which the firing detection circuit 4 is embodied. The firing detection circuit 4 of FIG. 10 includes a voltage comparator 4a. The voltage comparator 4a in FIG. 10 compares the cathode voltage of the photodetection element 2 with a threshold voltage controlled by the threshold control circuit 6, and outputs a signal indicating a comparison result. For example, the voltage comparator 4a outputs a high-level pulse signal in a case where the cathode voltage of the photodetection element 2 is lower than or equal to a threshold voltage.

The monitor circuit 5 includes, for example, a counter 12. The counter 12 counts the pulse signal output from the voltage comparator 4a. The threshold control circuit 6 detects an occurrence rate per unit time of the pulse signal on the basis of a count value of the counter 12, and controls the threshold voltage of the voltage comparator 4a on the basis of the detected occurrence rate according to the flowchart of FIG. 7 or 8.

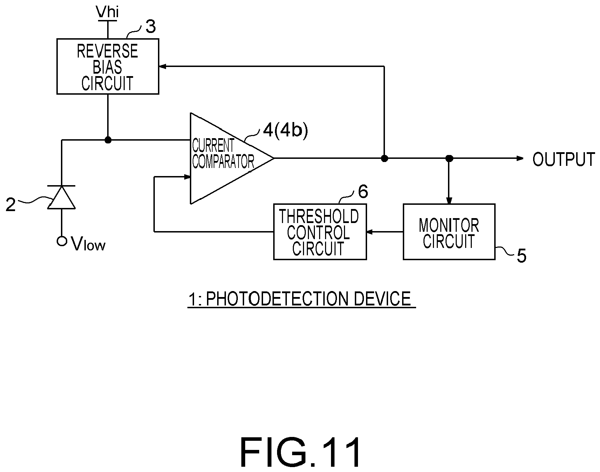

FIG. 11 is a block diagram of the photodetection device 1 according to a second specific example in which the firing detection circuit 4 is embodied. The firing detection circuit 4 of FIG. 11 includes a current comparator 4b. The current comparator 4b in FIG. 11 compares the cathode current of the photodetection element 2 with a threshold current controlled by the threshold control circuit 6, and outputs a signal indicating a comparison result. For example, the current comparator 4b outputs a high-level pulse signal when the cathode current of the photodetection element 2 is less than or equal to a threshold current. The monitor circuit 5 counts the pulse signal output from the current comparator 4b and detects an occurrence rate of the pulse signal per unit time. The threshold control circuit 6 controls the threshold current of the current comparator 4b based on the occurrence rate per unit time of the pulse signal.

As illustrated in FIG. 10, the monitor circuit 5 may be provided with the counter 12 that counts the number of pulse signals output from the firing detection circuit 4, or may detect firing in the firing detection circuit 4 by other means.

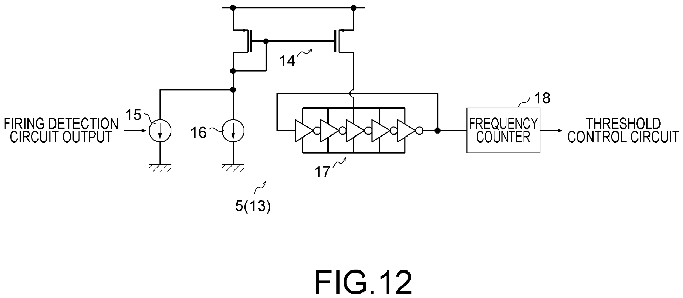

FIG. 12 is a block diagram illustrating a specific example of the monitor circuit 5. The monitor circuit 5 in FIG. 12 is a VCO based monitor circuit 13, and includes a current mirror circuit 14, a first current source 15, a second current source 16, a ring oscillator 17, and a frequency counter 18.

The first current source 15 and the second current source 16 are connected in parallel to the current mirror circuit 14. A current flowing through the first current source 15 is controlled based on an output signal of the firing detection circuit 4. When the current flowing through the first current source 15 changes, a power supply voltage supplied to the ring oscillator 17 changes, and a frequency of an oscillation signal generated by the ring oscillator 17 changes. The frequency counter 18 counts the frequency of the oscillation signal. As a result, a count value of the frequency counter 18 changes according to the comparison result of the firing detection circuit 4.

Although the monitor circuit 5 of FIG. 12 has a circuit scale larger than that of the monitor circuit 5 of FIG. 11, the comparison result can be accurately detected because a pulse width of the firing detection circuit 4 is also sensitive.

As described above, in the first example, the threshold of the firing detection circuit 4 is set on the basis of the dark count rate detected by the firing detection circuit 4 or the incidence rate of firing by ambient light. Specifically, since the threshold is set on the basis of the control range of the threshold in which the variation amount of the dark count rate or the incidence rate of firing by ambient light falls within a predetermined amount, the optimum threshold can be set in accordance with the characteristics of the photodetection element 2.

### (Second example)

In the second example, a plurality of photodetection elements 2 similar to the photodetection elements 2 according to the first example are arranged in a one-dimensional or two-dimensional direction.

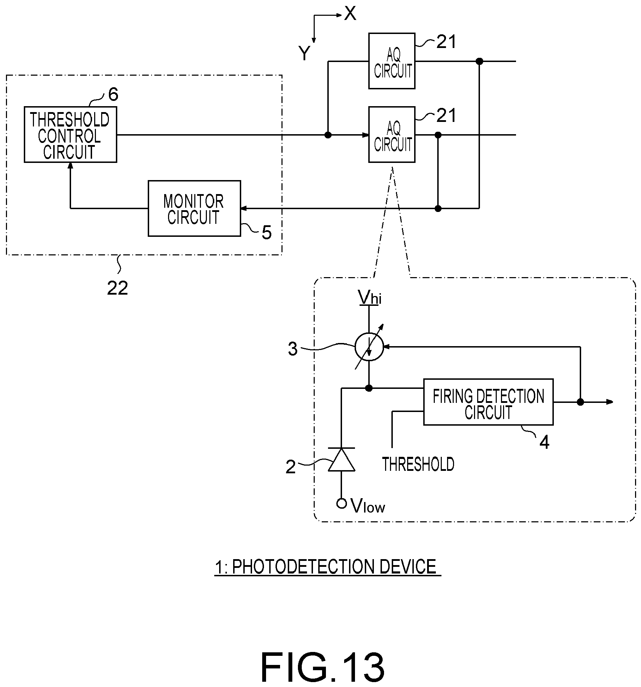

FIG. 13 is a block diagram illustrating a schematic configuration of a photodetection device 1 according to a second example. The photodetection device 1 of FIG. 13 includes a plurality of active quenching circuits (AQ circuits) 21 arranged in a one-dimensional or two-dimensional direction. Each of the active quenching circuits 21 includes a reverse bias circuit 3 and a firing detection circuit 4 described above.

FIG. 13 illustrates a configuration in which the plurality of active quenching circuits 21 are arranged in a predetermined direction Y, but the plurality of active quenching circuits 21 may also be arranged in a direction X intersecting the predetermined direction Y.

Output nodes of the plurality of active quenching circuits 21 arranged in the predetermined direction Y are all connected to an input node of a monitor circuit 5. An output node of a threshold control circuit 6 is connected to input nodes of the plurality of active quenching circuits 21.

As described above, in the photodetection device 1 of FIG. 13, one monitor circuit 5 and one threshold control circuit 6 are provided in association with the plurality of active quenching circuits 21. How many active quenching circuits 21 are provided for each of the one monitor circuit 5 and the one threshold control circuit 6 is arbitrary. In the present specification, the monitor circuit 5 and the threshold control circuit 6 corresponding to the plurality of active quenching circuits 21 are referred to as a threshold detection circuit 22.

An output signal of each of the firing detection circuits 4 in the plurality of active quenching circuits 21 is input to the monitor circuit 5 via a common signal wiring. As a result, the monitor circuit 5 counts the pulse signals output from the corresponding plurality of firing detection circuits 4. The threshold control circuit 6 sets a common threshold to the corresponding plurality of firing detection circuits 4 based on a count value counted by the monitor circuit 5. As a result, it is not necessary to provide the threshold detection circuit 22 including the monitor circuit 5 and the threshold control circuit 6 for each of the active quenching circuits 21, a mounting area of the threshold detection circuit 22 can be reduced, and the photodetection device 1 can be downsized.

Since the plurality of active quenching circuits 21 arranged adjacent to each other have the same or similar electrical characteristics, even if the thresholds of the respective firing detection circuits 4 in the plurality of active quenching circuits 21 are set to be common, a mismatch does not cause a problem.

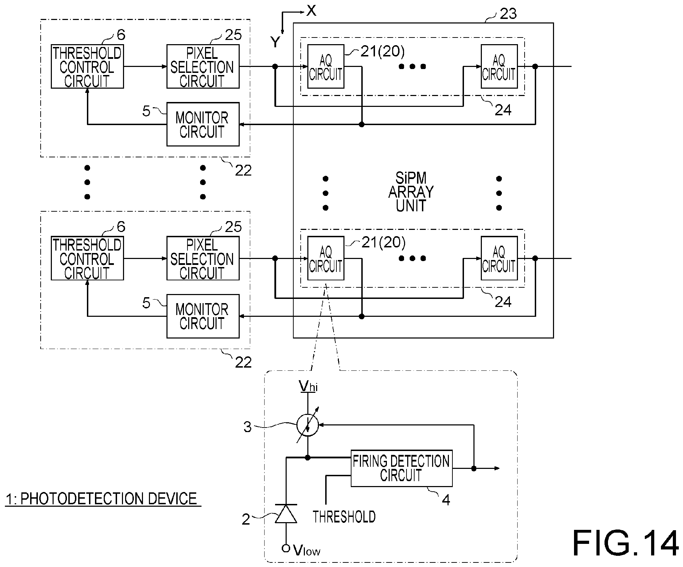

FIG. 14 is a block diagram illustrating a schematic configuration of a photodetection device 1 according to a modified example of FIG. 13. The photodetection device 1 of FIG. 14 includes a silicon photo-multiplier (SiPM) array unit 23 and a plurality of threshold detection circuits 22.

The SiPM array unit 23 includes a plurality of SiPMs 20 arranged along a first direction X and a second direction Y. Each of the SiPMs constitutes a pixel. Each of the SiPMs has one or more active quenching circuits 21. Each of the active quenching circuits 21 includes a photodetection element 2 and a firing detection circuit 4.

In the example of FIG. 14, the photodetection device 1 includes each of the threshold detection circuits 22 for each active quenching circuit group 24 including the plurality of active quenching circuits 21 arranged along the first direction X. The plurality of threshold detection circuits 22 is arranged along the second direction Y, and each of the threshold detection circuits 22 is provided for each corresponding active quenching circuit group 24.

Each of the threshold detection circuits 22 includes a monitor circuit 5, a threshold control circuit 6, and a pixel selection circuit 25. Output nodes of the plurality of active quenching circuits 21 belonging to the corresponding active quenching circuit group 24 are connected to an input node of the monitor circuit 5. More specifically, output nodes of the plurality of firing detection circuits 4 in the plurality of active quenching circuits 21 are connected to the input node of the monitor circuit 5.

The monitor circuit 5 in each of the threshold detection circuits 22 counts the pulse signal output from the firing detection circuit 4 in the active quenching circuit 21 selected by the pixel selection circuit 25 among the plurality of active quenching circuits 21 belonging to the corresponding active quenching circuit group 24. Based on the count value counted by the monitor circuit 5, the threshold control circuit 6 in each of the threshold detection circuits 22 controls the threshold of the firing detection circuit 4 in the active quenching circuit 21 selected by the pixel selection circuit 25 among the plurality of active quenching circuits 21 belonging to the corresponding active quenching circuit group 24.

In the photodetection device 1 of FIG. 14, since the threshold detection circuit 22 is provided for each active quenching circuit group 24 including the plurality of active quenching circuits 21 arranged in the first direction X, it is not necessary to provide the threshold detection circuit 22 for each of the active quenching circuits 21, and a mounting area of the threshold detection circuit 22 can be reduced. Furthermore, since the pixel selection circuit 25 is provided in the threshold detection circuit 22, the threshold can be individually controlled for each of the firing detection circuits 4 in the active quenching circuits 21 belonging to the active quenching circuit group 24.

As described above, in the second example, since the plurality of active quenching circuits 21 share one threshold detection circuit 22, it is not necessary to provide the threshold detection circuit 22 for each active quenching circuit 21, the mounting area of the threshold detection circuit 22 can be reduced, and the photodetection device 1 can be downsized. Accordingly, the active quenching circuits 21 can be mounted at a higher density, and the number of pixels of the SiPM array unit 23 can be increased to improve the resolution.

### (Third example)

In a third example, the photodetection device 1 according to the first or second example is applied to a distance measurement device.

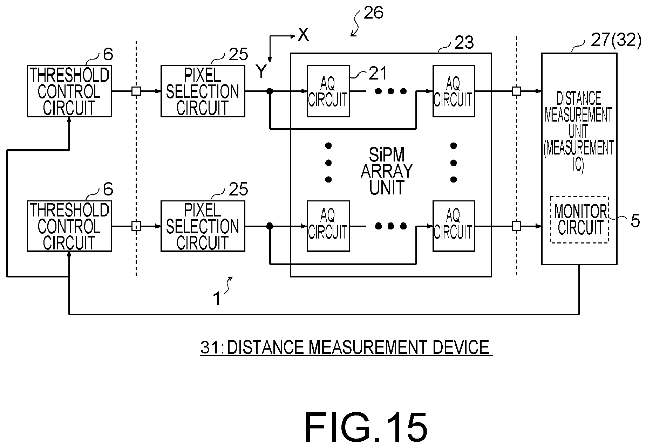

FIG. 15 is a block diagram illustrating a schematic configuration of a distance measurement device 31 including a photodetection device 1 according to a third example. A distance measurement device 31 of FIG. 15 includes a photodetection device 1 and a distance measurement unit 32. The photodetection device 1 of FIG. 15 has a configuration similar to that of the photodetection device 1 of FIG. 14, for example. While the photodetection device 1 of FIG. 14 includes the threshold detection circuits 22 each including the monitor circuit 5, the threshold control circuit 6, and the pixel selection circuit 25, the photodetection device 1 of FIG. 15 integrates the monitor circuit 5 illustrated in FIG. 1 and the like into the distance measurement unit 32.

The distance measurement unit 32 includes a light emitting unit that projects light to an object, a light receiving unit that receives reflected light obtained by reflecting the projected light by the object, and a distance measurement section that measures a distance of the object on the basis of a time difference between a light projection timing and a light reception timing of the light. The distance measurement unit 32 incorporates, for example, a counter that measures the number of received pulses, and this counter is used by the monitor circuit 5. As a result, it is not necessary to provide the dedicated counter 12 for the monitor circuit 5, and the circuit scale of the distance measurement device 31 can be reduced. In addition, even in a case where the counter is not provided, the number of dark pulses can be estimated from an amplitude histogram of an AD conversion result of the output signal of the photodetection device 1 subjected to distance measurement.

An SiPM array unit 23 including a plurality of SiPMs 20 arranged in the two-dimensional direction and a pixel selection circuit 25 are disposed in, for example, a first semiconductor device 26. The distance measurement unit 32 including the monitor circuit 5 is disposed in a second semiconductor device 27, for example. The second semiconductor device 27 is also referred to as a measurement IC. Threshold control circuits 6 are disposed in the second semiconductor device 27 or disposed in a third semiconductor device (not illustrated). As described above, the distance measurement device 31 in FIG. 15 can be realized by at least two semiconductor devices including the first semiconductor device 26 and the second semiconductor device 27.

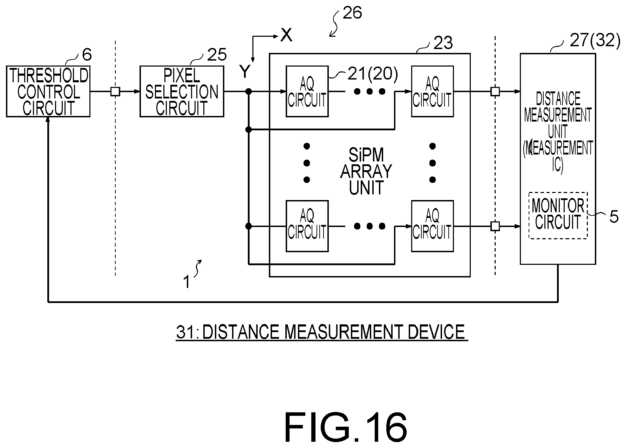

FIG. 16 is a block diagram illustrating a schematic configuration of a distance measurement device 31 according to a first modified example of the third example. A photodetection device 1 in the distance measurement device 31 of FIG. 16 includes one pixel selection circuit 25 for a plurality of active quenching circuit groups 24 arranged in the first direction X and the second direction Y in an SiPM array unit 23. For example, by using a control method such as inter integrated circuit (I2C), a threshold of the selected pixel can be sequentially set. Although the pixel selection circuit 25 and the SiPM array unit 23 are disposed in a first semiconductor device 26, since the number of pixel selection circuits 25 in the first semiconductor device 26 can be reduced as compared with FIG. 15, the first semiconductor device 26 can be downsized, the SiPM array unit 23 in the first semiconductor device 26 can be highly integrated, and resolution can be improved.

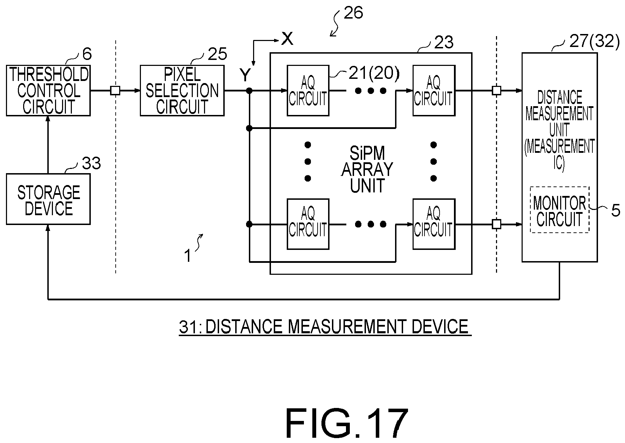

FIG. 17 is a block diagram illustrating a schematic configuration of a distance measurement device 31 according to a second modified example of the third example. The distance measurement device 31 in FIG. 17 includes a storage device 33 in addition to the configuration in FIG. 16. The storage device 33 stores a count value counted by a monitor circuit 5 in a second semiconductor device 27. The storage device 33 stores the pulse signal output from a firing detection circuit 4 in an active quenching circuit 21 selected by a pixel selection circuit 25 in association with the active quenching circuit 21. A threshold control circuit 6 reads the count value corresponding to the active quenching circuit 21 selected by the pixel selection circuit 25 from the storage device 33, and controls the threshold of the firing detection circuit 4 in the corresponding active quenching circuit 21. The storage device 33 is disposed in the second semiconductor device 27 or a third semiconductor device (not illustrated).

The monitor circuit 5 in the second semiconductor device 27 counts the pulse signal detected by the firing detection circuit 4 in the active quenching circuit 21 selected by the pixel selection circuit 25 during a blanking period or the like in which the distance measurement unit 32 does not perform distance measurement, and stores the count value in the storage device 33. As a result, the threshold control circuit 6 can read the count value from the storage device 33 immediately before the distance measurement unit 32 starts the distance measurement processing, control the threshold of the firing detection circuit 4, and quickly perform the distance measurement processing in a state where the optimum threshold is set in the firing detection circuit 4. Note that a storage device 33 similar to that in FIG. 17 may be added to the distance measurement device 31 in FIG. 15.

As described above, in the third example, since the function of the monitor circuit 5 is provided in the second semiconductor device 27 including the distance measurement unit 32, it is not necessary to provide the monitor circuit 5 inside the first semiconductor device 26 including the SiPM array unit 23 and the pixel selection circuit 25, and the distance measurement device 31 can be downsized. Furthermore, by providing the threshold control circuit 6 in a semiconductor device other than the first semiconductor device 26, it is possible to reduce the size of the first semiconductor device 26 or improve the pixel resolution of the SiPM array unit 23.

Moreover, since the storage device 33 that stores the count value counted by the monitor circuit 5 or the threshold set by the threshold control unit is provided, it is not necessary to perform processing of searching for an optimum threshold every time the distance measurement processing is performed, the frame rate can be increased, and power consumption can be reduced by reducing the number of times of searching.

The above-described examples may be configured as follows.
(1) A photodetection device comprising:
   a photodetection element;
   an reset circuit that sets one end of the photodetection element to a predetermined initialization voltage;
   a firing detection circuit that detects firing of the photodetection element by comparing a voltage at the one end of the photodetection element or a current flowing through the one end with a threshold;
   a monitor circuit that monitors an output signal of the firing detection circuit; and
   a threshold control circuit that controls the threshold based on a monitor output of the monitor circuit.
(2) The photodetection device according to (1), wherein
   when the firing detection circuit detects firing, the reset circuit returns the one end of the photodetection element to the initialization voltage based on the output signal of the firing detection circuit.
(3) The photodetection device according to (1), wherein
   when the firing detection circuit detects firing, the reset circuit returns the one end of the photodetection element to the initialization voltage regardless of the output signal of the firing detection circuit.
(4) The photodetection device according to any one of (1) to (3), wherein
   the firing detection circuit detects firing of the photodetection element in a situation where the photodetection element is shielded from light or in a situation where ambient light with uniform illuminance is incident on the photodetection element.
(5) The photodetection device according to (4), wherein
   the firing detection circuit detects firing by a dark count or ambient light having sensitivity to the threshold.
(6) The photodetection device according to any one of (1) to (5), wherein
   the firing detection circuit includes a voltage comparator that compares a voltage of the one end of the photodetection element with a threshold voltage, and outputs a binary signal indicating a comparison result,
   the monitor circuit includes a counter that monitors a number of signal changes of the binary signal, and
   the threshold control circuit controls the threshold voltage based on the monitor output of the monitor circuit.
(7) The photodetection device according to any one of (1) to (5), wherein
   the firing detection circuit includes a current comparator that compares a current flowing through the one end of the photodetection element with a threshold current, and
   the threshold control circuit controls the threshold current based on the monitor output of the monitor circuit.
(8). The photodetection device according to (6) or (7), wherein
   the firing detection circuit outputs a signal according to a comparison result between a signal of the one end of the photodetection element and the threshold,
   the monitor circuit includes
   an oscillator that outputs an oscillation signal having a frequency according to an output signal of the firing detection circuit, and
   a frequency counter that detects a frequency of the oscillation signal, and
   the threshold control circuit controls the threshold based on a count value of the frequency counter.
(9) The photodetection device according to any one of (1) to (8), wherein
   the firing detection circuit outputs a pulse signal having an occurrence rate according to the threshold, and
   the threshold control circuit controls the threshold based on the occurrence rate of the pulse signal.
(10) The photodetection device according to (9), wherein
   the threshold control circuit continuously or stepwise changes the threshold, and sets, in the firing detection circuit, the threshold when a variation amount of the occurrence rate of the pulse signal falls within a predetermined amount.
(11) The photodetection device according to (10), wherein
   the threshold control circuit sets the threshold to a median value of a control range of the threshold in which a variation amount of the occurrence rate of the pulse signal falls within the predetermined amount.
(12) The photodetection device according to (10), wherein
   the threshold control circuit sets the threshold to a minimum value of a control range of the threshold in which a variation amount of the occurrence rate of the pulse signal falls within the predetermined amount.
(13) The photodetection device according to any one of (1) to (12), further comprising
   a pixel array including a plurality of the photodetection elements arrayed in a one-dimensional or two-dimensional direction,
   wherein the monitor circuit and the threshold control circuit are shared by two or more of the photodetection elements,
   the firing detection circuit is provided for each of the plurality of photodetection elements, and
   the threshold control circuit controls the threshold of two or more of the firing detection circuits corresponding to the two or more photodetection elements to be shared.
(14) The photodetection device according to any one of (1) to (12), further comprising:
   a photodetection element group including a plurality of the photodetection elements arranged in a predetermined direction; and
   a selection circuit that selects any of the photodetection elements in the photodetection element group,
   wherein the firing detection circuit, the monitor circuit, and the threshold control circuit are provided corresponding to the photodetection element group,
   the monitor circuit monitors an output signal of the firing detection circuit corresponding to the photodetection elements selected by the selection circuit among the corresponding photodetection element groups, and
   the threshold control circuit controls the threshold of the firing detection circuit corresponding to the photodetection elements selected by the selection circuit based on the monitor output of the monitor circuit.
(15) A distance measurement device comprising:
   the photodetection device according to (14); and
   a distance measurer that projects light to an object, receive reflected light from the object, and measure a distance of the object based on a time difference between a light projection timing and a light reception timing,
   wherein the monitor circuit monitors an output signal of the firing detection circuit using a circuit included in the distance measurer.
(16) The distance measurement device according to (15), further comprising
   a storage that stores control information of the threshold controlled by the threshold control circuit,
   wherein the threshold control circuit reads the control information of the threshold stored in the storage at a time of power supply or initialization, and controls the threshold.
(17) The distance measurement device according to (15), further comprising:
   a first semiconductor device including the photodetection element group, the firing detection circuit, and the selection circuit; and
   a second semiconductor device including the distance measurer and the monitor circuit.
(18) The distance measurement device according to (16), further comprising:
   a first semiconductor device including the photodetection element group, the firing detection circuit, and the selection circuit; and
   a second semiconductor device including the distance measurer and the monitor circuit,
   wherein the threshold control circuit and the storage are disposed in the second semiconductor device, or disposed in a third semiconductor device separate from the first and second semiconductor devices.
(19) The distance measurement device according to any one of (15) to (18), wherein
   when the firing detection circuit detects firing, the reset circuit returns the one end of the photodetection element to the initialization voltage based on the output signal of the firing detection circuit.
(20) The photodetection device according to any one of (15) to (18), wherein
   when the firing detection circuit detects firing, the reset circuit returns the one end of the photodetection element to the initialization voltage regardless of the output signal of the firing detection circuit.

While certain examples have been described, these examples have been presented by way of example only, and are not intended to limit the scope of the disclosures. Indeed, the novel methods and systems described herein may be embodied in a variety of other forms; furthermore, various omissions, substitutions and changes in the form of the methods and systems described herein may be made without departing from the spirit of the disclosures. The accompanying claims and their equivalents are intended to cover such forms or modifications as would fall within the scope and spirit of the disclosures.

## Claims

1. A photodetection device (1) comprising:
a photodetection element (2);
an reset circuit (3) that sets one end of the photodetection element (2) to a predetermined initialization voltage;
a firing detection circuit that detects firing of the photodetection element (2) by comparing a voltage at the one end of the photodetection element (2) or a current flowing through the one end with a threshold;
a monitor circuit (5) that monitors an output signal of the firing detection circuit; and
a threshold control circuit (6) that controls the threshold based on a monitor output of the monitor circuit (5).

2. The photodetection device (1) according to claim 1, wherein
when the firing detection circuit (4) detects firing, the reset circuit (3) returns the one end of the photodetection element (2) to the initialization voltage based on the output signal of the firing detection circuit (4).

3. The photodetection device (1) according to claim 1, wherein
when the firing detection circuit (4) detects firing, the reset circuit (3) returns the one end of the photodetection element (2) to the initialization voltage regardless of the output signal of the firing detection circuit (4).

4. The photodetection device (1) according to any one of claims 1-3, wherein
the firing detection circuit (4) detects firing of the photodetection element (2) in a situation where the photodetection element (2) is shielded from light or in a situation where ambient light with uniform illuminance is incident on the photodetection element (2).

5. The photodetection device (1) according to claim 4, wherein
the firing detection circuit (4) detects firing by a dark count or ambient light having sensitivity to the threshold.

6. The photodetection device (1) according to any one of claims 1-5, wherein
the firing detection circuit (4) includes a voltage comparator (4a) that compares a voltage of the one end of the photodetection element (2) with a threshold voltage, and outputs a binary signal indicating a comparison result,
the monitor circuit (5) includes a counter (12) that monitors a number of signal changes of the binary signal, and
the threshold control circuit (6) controls the threshold voltage based on the monitor output of the monitor circuit (5).

7. The photodetection device (1) according to any one of claims 1-5, wherein
the firing detection circuit (4) includes a current comparator (4b) that compares a current flowing through the one end of the photodetection element (2) with a threshold current, and
the threshold control circuit (6) controls the threshold current based on the monitor output of the monitor circuit (5).

8. The photodetection device (1) according to claim 6 or 7, wherein
the firing detection circuit (4) outputs a signal according to a comparison result between a signal of the one end of the photodetection element (2) and the threshold,
the monitor circuit (5) includes
an oscillator that outputs an oscillation signal having a frequency according to an output signal of the firing detection circuit (4), and
a frequency counter (12) that detects a frequency of the oscillation signal, and
the threshold control circuit (6) controls the threshold based on a count value of the frequency counter (12).

9. The photodetection device (1) according to any one of claims 1-8, wherein
the firing detection circuit (4) outputs a pulse signal having an occurrence rate according to the threshold, and
the threshold control circuit (6) controls the threshold based on the occurrence rate of the pulse signal, or continuously or stepwise changes the threshold, and sets, in the firing detection circuit (4), the threshold when a variation amount of the occurrence rate of the pulse signal falls within a predetermined amount.

10. The photodetection device (1) according to claim 9, wherein
the threshold control circuit (6) sets the threshold to a median value of a control range of the threshold in which a variation amount of the occurrence rate of the pulse signal falls within the predetermined amount, or sets the threshold to a minimum value of a control range of the threshold in which a variation amount of the occurrence rate of the pulse signal falls within the predetermined amount.

11. The photodetection device (1) according to any one of claims 1-10, further comprising
a pixel array including a plurality of the photodetection elements (2) arrayed in a one-dimensional or two-dimensional direction,
wherein the monitor circuit (5) and the threshold control circuit (6) are shared by two or more of the photodetection elements (2),
the firing detection circuit (4) is provided for each of the plurality of photodetection elements (2), and
the threshold control circuit (6) controls the threshold of two or more of the firing detection circuits (4) corresponding to the two or more photodetection elements (2) to be shared.

12. The photodetection device (1) according to any one of claims 1-10, further comprising:
a photodetection element group including a plurality of the photodetection elements (2) arranged in a predetermined direction; and
a selection circuit (25) that selects any of the photodetection elements (2) in the photodetection element group,
wherein the firing detection circuit (4), the monitor circuit (5), and the threshold control circuit (6) are provided corresponding to the photodetection element group,
the monitor circuit (5) monitors an output signal of the firing detection circuit (4) corresponding to the photodetection elements (2) selected by the selection circuit (25) among the corresponding photodetection element groups, and
the threshold control circuit (6) controls the threshold of the firing detection circuit (4) corresponding to the photodetection elements (2) selected by the selection circuit (25) based on the monitor output of the monitor circuit (5).

13. A distance measurement device (31) comprising:
the photodetection device (1) according to claim 12; and
a distance measurer (32) that projects light to an object, receive reflected light from the object, and measure a distance of the object based on a time difference between a light projection timing and a light reception timing,
wherein the monitor circuit (5) monitors an output signal of the firing detection circuit (4) using a circuit included in the distance measurer (32).

14. The distance measurement device according to claim 13, further comprising
a storage (33) that stores control information of the threshold controlled by the threshold control circuit (6),
wherein the threshold control circuit (6) reads the control information of the threshold stored in the storage (33) at a time of power supply or initialization, and controls the threshold.

15. The distance measurement device according to claim 13, further comprising:
a first semiconductor device (26) including the photodetection element group, the firing detection circuit (4), and the selection circuit (25); and
a second semiconductor device (27) including the distance measurer (32) and the monitor circuit (5), or
a first semiconductor device (26) including the photodetection element group, the firing detection circuit (4), and the selection circuit (25); and
a second semiconductor device (27) including the distance measurer (32) and the monitor circuit (5),
wherein the threshold control circuit (6) and the storage (33) are disposed in the second semiconductor device (27), or disposed in a third semiconductor device separate from the first and second semiconductor devices (26) (27).
